(19) **Europäisches Patentamt**
European Patent Office
Office européen des brevets

(11) **EP 3 025 160 B1**

(12) **EUROPÄISCHE PATENTSCHRIFT**

(45) Veröffentlichungstag und Bekanntmachung des Hinweises auf die Patenterteilung:
**21.08.2019 Patentblatt 2019/34**

(51) Int Cl.:
*G01R 23/12* *(2006.01)*     *G01R 23/02* *(2006.01)*
*G01R 19/25* *(2006.01)*

(21) Anmeldenummer: **13766245.8**

(86) Internationale Anmeldenummer:
**PCT/EP2013/068800**

(22) Anmeldetag: **11.09.2013**

(87) Internationale Veröffentlichungsnummer:
**WO 2015/036016 (19.03.2015 Gazette 2015/11)**

(54) **FREQUENZMESSUNG IN ENERGIEVERSORGUNGSNETZEN**

FREQUENCY MEASUREMENT IN ENERGY SUPPLY NETWORK

MESURE DE FRÉQUENCE DANS UN RÉSEAU D'ALIMENTATION EN ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.06.2016 Patentblatt 2016/22**

(73) Patentinhaber: **Siemens Aktiengesellschaft 80333 München (DE)**

(72) Erfinder: **LITZINGER, Andreas 90765 Fürth (DE)**

(56) Entgegenhaltungen:
**EP-A1- 0 311 825     EP-A1- 2 113 776**
**EP-B1- 2 095 482     DE-A1-102007 037 060**
**GB-A- 2 027 297**

**Beschreibung**

Die Erfindung betrifft ein Verfahren zum Erzeugen eines Frequenzmesswertes, der eine an einer Messstelle in einem Energieversorgungsnetz vorliegende Frequenz einer elektrischen Netzgröße angibt, bei dem mit einer Messeinrichtung ein die Netzgröße charakterisierendes Signal abgetastet wird und aus den Abtastwerten der Frequenzmesswert bestimmt wird. Die Erfindung betrifft auch ein entsprechendes Messgerät zum Erzeugen eines Frequenzmesswertes.

Die Messung einer Frequenz von elektrischen Netzgrößen wie einer Netzspannung und/oder eines Netzstromes stellt eine wichtige Aufgabe bei der Steuerung und Überwachung elektrischer Energieversorgungsnetze, z.B. durch sogenannte SCADA-Systeme (Supervisory Control and Data Acquisition) oder Energie Management Systeme (EMS), dar. Die aktuelle Frequenz im Energieversorgungsnetz wird beispielsweise zur Beurteilung einer Lastsituation im Energieversorgungsnetz, für die Erkennung eines spontanen Überschusses bzw. Mangels erzeugter elektrischer Energie, was sich in einem Frequenzanstieg bzw. -abfall äußert, oder auch zur Leistungsregelung von Kraftwerken verwendet. Ziel ist, die Frequenz im Energieversorgungsnetz möglichst exakt an der der Nennfrequenz (z.B. 50Hz im Europäischen Verbundnetz, 60Hz im Nordamerikanischen Stromnetz) zu halten. Sinkt die aktuelle Frequenz, müssen Regelkraftwerke mehr elektrische Leistung erzeugen und ins Netz einspeisen, da die Frequenz ein Indikator für die Balance zwischen Erzeugung und Verbrauch ist.

Die Leistungsregelung eines elektrischen Energieversorgungsnetzes erfolgt beispielsweise als Primärregelung in den vorhandenen Kraftwerken, als Sekundärregelung in Netzreglern der Verbundpartner und als Tertiärregelung bei einem führenden Verbundpartner. Würde man zur Netzführung lediglich die Primärregelung einsetzen, würde es zu einer bleibenden Abweichung der Ist-Frequenz von der Sollfrequenz kommen, wenn ein Kraftwerk ausfällt oder die tatsächliche elektrische Last nicht exakt der Lastprognose folgt. Die Ausregelung einer bestehenden Frequenzabweichung ist somit als Aufgabe der Sekundärregelung anzusehen, die zentral in der Leitstelle des Verbundpartners installiert ist und dafür sorgt, dass wieder die Sollfrequenz erreicht wird, indem für bestimmte Kraftwerke der Leistungssollwert angepasst wird. Die Tertiärregelung sorgt schließlich dafür, dass über die Dauer eines Tages der Mittelwert der Frequenz im Energieversorgungsnetz auf genau 50 Hz liegt. Auf diese Weise kann z.B. sichergestellt werden, dass sich Synchronuhren ordnungsgemäß auf die Netzfrequenz synchronisieren können und die exakte Zeit angeben.

Allen Regelmechanismen gemeinsam ist die Notwendigkeit über die Verfügbarkeit eines Frequenzmesswertes, der möglichst exakt die aktuelle Netzfrequenz angibt.

Bisher wurde die Frequenz in einem Energieversorgungsnetz meist mit vergleichsweise aufwändigen Frequenzmessverfahren bestimmt. Beispielsweise ist aus der DE 31 49 165 A1 ein Verfahren zur Messung einer Frequenz bekannt, bei dem bei jedem Nulldurchgang einer elektrischen Netzgröße in Form einer Wechselspannung ein Zähler gestartet wurde. Der Zählerstand am Ende einer Periode der Wechselspannung wird zur Ermittlung der Frequenz herangezogen. Ein anderes Verfahren ist in der DE 42 11 946 C1 beschrieben. Bei dem hieraus bekannten Verfahren wird eine elektrische Netzgröße, z.B. eine Spannung oder ein Strom, abgetastet und die Abtastwerte mehreren Filterstufen zugeführt. Als Ergebnis eines komplexen Filter- und Berechnungsprozesses wird ein die aktuelle Frequenz angebender Frequenzmesswert gebildet. Siehe auch EP 0 311 825, GB 2 027 297, EP 2 113 776 und DE 10 2007 037060.

Heutzutage werden zur Überwachung elektrischer Energieversorgungsnetze, beispielsweise im Umfeld sogenannter "Wide Area Monitoring Systeme", häufig Zeigermesseinheiten, sogenannte "Phasor Measurement Units" (PMU), eingesetzt, die in der Lage sind, neben genauen Informationen über aktuelle Phasenströme und/oder Phasenspannungen, z.B. durch die bereits erwähnte Erkennung von Nulldurchgängen der Strom- bzw. Spannungssignale, auch einen Frequenzmesswert zu ermitteln und auszugeben. Die Verwendung von PMUs zur Überwachung von Energieversorgungsnetzen ist beispielsweise aus der EP 2 095 482 B1 bekannt. Der von einer PMU bereitgestellte Frequenzmesswert ist jedoch in der Regel eher ungenau und von einem hohen Signalrauschen überlagert, so dass er nicht zur angesprochenen Regelung eines Energieversorgungsnetzes eingesetzt werden kann. Daher werden üblicherweise weiterhin separate Frequenzmesssysteme vorgehalten, deren Anschaffung und Wartung mit relativ hohen Kosten verbunden ist.

Der Erfindung liegt die Aufgabe zugrunde, ein Verfahren der eingangs angegebenen Art derart weiterzubilden, dass mit vergleichsweise geringem messtechnischen Aufwand ein möglichst exakter Frequenzmesswert erzeugt werden kann. Aufgabe der Erfindung ist ferner auch, ein entsprechendes Messgerät anzugeben.

Zur Lösung dieser Aufgabe wird hinsichtlich des Verfahrens vorgeschlagen, dass der Phasenwinkel ermittelt wird, der zwischen zwei aufeinander folgenden Abtastwerten der Netzgröße liegt, und der Frequenzmesswert unter Heranziehung des ermittelten Phasenwinkels berechnet wird.

Das erfindungsgemäße Verfahren setzt somit vorteilhaft die Erkenntnis ein, dass aus der Messung eines Phasenwinkels, der zwischen zwei Abtastwerten der Netzgröße überstrichen wird und mit heutigen Messsystemen mit relativ hoher Genauigkeit erfasst werden kann, ein Rückschluss auf die aktuelle Frequenz der Netzgröße gezogen werden kann. Da für die Messung lediglich zwei Abtastwerte sowie eine Information über den dazwischenliegenden Phasenwinkel benötigt werden, ist das erfindungsgemäße Verfahren mit vergleichsweise geringem messtechnischen Aufwand durchführbar.

Konkret kann zur Ermittlung des Frequenzmesswertes zudem vorgesehen sein, dass der Frequenzmesswert unter Heranziehung des ermittelten Phasenwinkels, der Nennfrequenz des Energieversorgungsnetzes und der Abtastrate, mit der die Abtastwerte erzeugt werden, berechnet wird. Wenn nachfolgend von einem Phasenwinkel gesprochen wird, ist damit konkret eine Phasenwinkeldifferenz zwischen einem ersten Phasenwinkel des ersten Abtastwertes und einem zweiten Phasenwinkel des zweiten Abtastwertes gemeint. Die folgenden Ausführungen sind in entsprechender Weise zu verstehen.

Die neben dem Phasenwinkel benötigten Informationen über die Nennfrequenz des Energieversorgungsnetzes und die verwendete Abtastrate der Messeinrichtung sind feste Größen, die einfach ermittelt und als Parameter vorgegeben werden können.

Gemäß einer vorteilhaften Ausführungsform des erfindungsgemäßen Verfahrens ist zudem vorgesehen, dass der Phasenwinkel zwischen zwei unmittelbar aufeinander folgenden Abtastwerten der Netzgröße ermittelt wird.

Auf diese Weise kann der Frequenzmesswert vergleichsweise schnell, nämlich bereits nach Erfassung zweier unmittelbar aufeinander folgender Abtastwerte bestimmt werden.

Konkret kann hinsichtlich der elektrischen Netzgröße vorgesehen sein, dass als Netzgröße eine an der Messstelle vorliegende Spannung oder ein an der Messstelle fließender Strom verwendet wird.

Die Erfindung sieht vor, dass als Messeinrichtung eine Zeigermesseinheit verwendet wird.

Solche auch als Phasor Measurement Units (PMU) bezeichnete Messgeräte werden mittlerweile vielfach zur Überwachung elektrischer Energieversorgungsnetzen, z.B. in Zusammenhang mit SCADA- oder Wide-Area-Monitoring-Systemen, eingesetzt. Wie eingangs bereits erwähnt, können existierende PMUs bisher jedoch nur ungenaue Frequenzmessungen durchführen. Sie sind hingegen dazu eingerichtet, eine vergleichsweise genaue Messung eines Phasenwinkels der abgetasteten Netzgröße durchzuführen, so dass sie die für das erfindungsgemäße Verfahren benötigten Informationen mit guter Genauigkeit bereitstellen können. Eine zusätzliche Ausnutzung der von den vorhandenen PMUs gelieferten Informationen über die Phasenwinkel könnte zudem meist ohne hohe Zusatzkosten erfolgen, ein separates System zur Frequenzmessung könnte ggf. komplett entfallen.

Konkret kann hinsichtlich der Ermittlung des Frequenzmesswertes vorgesehen sein, dass der Frequenzmesswert gemäß der folgenden Gleichung ermittelt wird:

$$ f = f_n \cdot \left( 1 + \frac{\Delta\varphi}{360°} \cdot \frac{r}{f_n} \right), $$

mit

f :      zu ermittelnder Frequenzmesswert,
$f_n$ :      Nennfrequenz des Energieversorgungsnetzes,
$\Delta\varphi$ :      ermittelter Phasenwinkel,
r :      Abtastrate des Messgerätes.

Die Erfindung sieht vor, dass der Frequenzmesswert wiederholt ermittelt wird, und ein abgeleiteter Frequenzmesswert aus mehreren während einer Messzeit aufeinander folgend ermittelten Frequenzmesswerten berechnet wird.

Durch das Heranziehen der Werte mehrerer innerhalb einer Messzeit von beispielsweise 1s ermittelter Frequenzmesswerte lässt sich erreichen, dass etwaige Messungenauigkeiten bei der Ermittlung des Phasenwinkels ausgeglichen werden und der abgeleitete Frequenzmesswert somit mit sehr hoher Genauigkeit angegeben werden kann.

In diesem Zusammenhang kann beispielsweise vorgesehen sein, dass der abgeleitete Frequenzmesswert durch Mittelwertbildung aus den mehreren ermittelten Frequenzmesswerten berechnet wird.

Die Mittelung kann beispielsweise als arithmetisches Mittel, geometrisches Mittel, durch Effektivwertbildung oder durch Bildung eines sogenannten RMS-Wertes (rout mean square) durchgeführt werden.

Hinsichtlich des Messgerätes wird die oben genannte Aufgabe durch ein elektrisches Messgerät zum Erzeugen eines Frequenzmesswertes, der eine an einer Messstelle in einem Energieversorgungsnetz vorliegende Frequenz einer Netzgröße angibt, gelöst, das mit einer Messeinrichtung verbindbar ist, die dazu eingerichtet ist, ein die Netzgröße charakterisierendes Signal unter Bildung von Abtastwerten abzutasten, aus denen der Frequenzmesswert bestimmbar ist.

Erfindungsgemäß ist vorgesehen, dass das elektrische Messgerät zur Durchführung eines Verfahrens gemäß einem der Ansprüche 1-5 eingerichtet ist.

Hinsichtlich der Vorteile des erfindungsgemäßen Messgerätes wird auf die zu dem erfindungsgemäßen Verfahren beschriebenen Vorteile verwiesen. Das erfindungsgemäße Messgerät ist dazu eingerichtet, jede Ausführungsform des erfindungsgemäßen Verfahrens auszuführen, so dass alles zu dem Verfahren Gesagte auch auf das Messgerät - und umgekehrt - bezogen werden kann. Hinsichtlich einer vorteilhaften Ausführungsform des erfindungsgemäßen Messgerätes kann vorgesehen sein, dass das elektrische Messgerät die Messeinrichtung umfasst.

In diesem Fall wird der Frequenzmesswert direkt in dem elektrischen Messgerät gebildet und kann nachgelagerten Einrichtungen, z.B. einer Datenverarbeitungseinrichtung einer Netzleitstelle, zur Verfügung gestellt werden. Ein solches Messgerät kann beispielsweise als Zeigermesseinheit (Phasor Measurement Unit) ausgebildet sein.

Alternativ kann jedoch auch vorgesehen sein, dass das elektrische Messgerät über eine Kommunikationsverbindung mit der Messeinrichtung verbindbar und dazu eingerichtet ist, über die Kommunikationsverbindung die Abtastwerte und/oder den aus den Abtastwerten ermittelten Phasenwinkel zu empfangen und daraus den Frequenzmesswert zu bestimmen.

In diesem Fall wird von der Messeinrichtung, die üblicherweise in der Nähe der Messstelle im Energieversorgungsnetz angeordnet ist, lediglich eine Bildung der Abtastwerte und/oder eine Bestimmung des Phasenwinkels vorgenommen, während die Ermittlung des Frequenzmesswertes erst in dem Messgerät, das beispielsweise Bestandteil einer Datenverarbeitungseinrichtung einer Netzleitstelle sein kann, durchgeführt wird. Auf diese Weise kann beispielsweise auch ein Messsystem aufgebaut werden, bei dem an mehreren Messstellen lediglich Messeinrichtungen zur Erzeugung der Abtastwerte und/oder Phasenwinkel vorhanden sein müssen, und die eigentliche Frequenzmessung lediglich zentral von einem entsprechend leistungsstärkeren Messgerät durchgeführt wird.

Die Erfindung wird nachfolgend anhand von Ausführungsbeispielen näher erläutert. Hierzu zeigt

Figur 1     eine schematische Ansicht eines Messgerätes mit integrierter Messeinrichtung zur Erzeugung eines Frequenzmesswertes; und

Figur 2     eine schematische Ansicht eines Messsystems mit einem Messgerät und mehreren verteilten Messeinrichtungen.

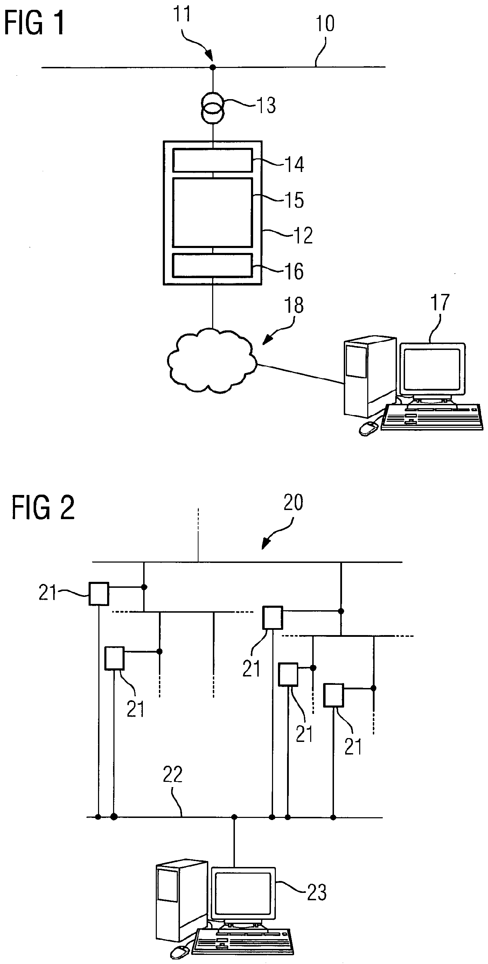

Figur 1 zeigt in schematischer Ansicht einen Teil einer Leitung 10 eines ansonsten nicht näher dargestellten elektrischen Energieversorgungsnetzes. An einer Messstelle 11 ist ein elektrisches Messgerät 12 angeordnet, bei dem es sich beispielsweise um eine Phasor Measurement Unit (PMU) handeln kann. Mittels eines lediglich schematisch angedeuteten Primärwandlers 13 wird ein Signal einer Netzgröße in Form einer Wechselspannung erfasst und an eine in das Messgerät 12 integrierte Messeinrichtung 14 übermittelt. In Figur 1 ist das Verfahren zur Messung einer Frequenz lediglich beispielhaft anhand der Messung einer Netzgröße in Form einer Wechselspannung erläutert, anstelle einer Spannungsmessung kann beispielsweise auch eine Strommessung durchgeführt werden. die Die Messeinrichtung 14 umfasst eine Abtasteinrichtung, die das Signal der Netzgröße abtastet und in entsprechende Abtastwerte umsetzt. Die Abtastwerte werden bevorzugt als Zeiger, im vorliegenden Fall als Spannungszeiger, dargestellt. Die Abtastwerte werden einer nachgelagerten Frequenzmesseinrichtung 15 zugeführt. Die Frequenzmesseinrichtung 15 ermittelt aus zwei aufeinander folgenden Abtastwerten einen zwischen den Abtastwerten liegenden Phasenwinkel $\Delta\varphi$. Bei Kenntnis der Netzfrequenz $f_n$ (beispielsweise 50Hz) und der Abtastrate r (Anzahl der Abtastungen pro Sekunde) der Messeinrichtung 14 kann die Frequenzmesseinrichtung 15 aus dem ermittelten Phasenwinkel $\Delta\varphi$ einen die aktuelle Frequenz der Netzgröße an der Messstelle 11 angebenden Frequenzmesswert f bestimmen. Dies kann insbesondere unter Anwendung der folgenden Gleichung erfolgen:

$$f = f_n \cdot \left(1 + \frac{\Delta\varphi}{360°} \cdot \frac{r}{f_n}\right),$$

mit

f :       zu ermittelnder Frequenzmesswert,
$f_n$ :       Nennfrequenz des Energieversorgungsnetzes,
$\Delta\varphi$ :       ermittelter Phasenwinkel,
r :       Abtastrate des Messgerätes.

Um eine möglichst kurze Messdauer zu erzielen, wird der Phasenwinkel insbesondere zwischen zwei unmittelbar aufeinander folgenden Abtastwerten bestimmt, es besteht jedoch auch die Möglichkeit, hierfür zwei Abtastwerte heranzuziehen, die nicht unmittelbar aufeinander folgen. Im letztgenannten Fall ist in der obigen Gleichung die Abtastrate entsprechend anzupassen.

Der Frequenzmesswert f kann daraufhin einer Kommunikationseinrichtung 16 des Messgerätes zugeführt und über eine beliebige Kommunikationsverbindung 18 an eine Datenverarbeitungseinrichtung 17, z.B. eine Workstation einer Netzleitstelle, übermittelt werden. In der Netzleitstelle kann der Frequenzmesswert zur Regelung des elektrischen Energieversorgungsnetzes herangezogen werden.

Die Messung des Phasenwinkels Δφ wird auch bei vergleichsweise genau arbeitenden Messgeräten mit einem gewissen Fehler behaftet sein. Beispielsweise definiert der Standard IEEE C37.118 zur Ermittlung sogenannter Synchronzeiger (Synchrophasor) eine Mindestanforderung an PMUs, wonach diese maximal eine Ungenauigkeit in Form eines sogenannten "Total Vector Errors" (TVE) von 1% aufweisen dürfen. Dies vorausgesetzt ergibt sich als Fehler δ bei der Messung der Phasenlage eines einzelnen Abtastwertes in Form eines Zeigers:

$$\delta = \arctan\left(\frac{V_f}{V}\right) = \arctan\left(\frac{1\% \cdot U}{U}\right) = \arctan(0{,}01) = 0{,}57° \text{ ,}$$

wobei V für den gemessenen (Spannungszeiger)-Abtastwert, $V_f$ für die Fehlerspannung und U für die Spannung an der Messstelle stehen. Daraus ergibt sich folglich ein Fehler bei der Bestimmung der Phasenlage eines Abtastwertes von 0,57°.

Einen solchen Fehler bei der Bestimmung der Phasenlage vorausgesetzt, kann der relative Fehler $F_r$ bei der Bestimmung des Frequenzmesswertes gemäß der folgenden Gleichung bestimmt werden:

$$F_r = \frac{\Delta f}{f_n} = \frac{f_{mess} - f_n}{f_n} = \frac{f_n \cdot \left(1 + \frac{0{,}057°}{360°}\right) - f_n}{f_n} = \frac{0{,}57°}{360°} = 0{,}158\% \text{ ,}$$

wobei $f_{mess}$ für die sich aus der Abtastrate r ergebende Frequenz bei der Abtastung der Netzgröße steht. Daraus ergibt sich folglich ein relativer Fehler bei der Bestimmung des Frequenzmesswertes von 0,158%. Bei einer Nennfrequenz von 50Hz entspricht dies einem absoluten Fehler $F_{abs}$ von

$$F_{abs} = 0{,}158\% \cdot 50Hz = 79{,}17mHz \text{ .}$$

Der ermittelte Frequenzmesswert kann somit auf etwa 80mHz genau bestimmt werden.

Es kann jedoch vorausgesetzt werden, dass sich der Fehler nicht für jede Messung in gleicher Weise auf den Frequenzmesswert aufaddiert. Diese Annahme ist begründet, da andernfalls die Phasenlagemessungen der PMU mit einem systematischen, sich kumulierenden Fehler behaftet wären und sich mit jeder Messung die gemessene Phasenlage von der tatsächlichen wegdrehen würde. Mit anderen Worten kann, da die Phasenlagemessungen über die Zeit keinen systematischen Fehler aufweisen, vorausgesetzt werden, dass sich auch die Ungenauigkeit bei den ermittelten Frequenzmesswerte über eine gewisse Zeitdauer betrachtet kompensiert, so dass die Frequenzmesseinrichtung 15 zur Erhöhung der Genauigkeit des erzeugten Ergebnisses einen abgeleiteten Frequenzmesswert bilden kann, der sich aus mehreren aufeinander folgend gebildeten Frequenzmesswerten ableitet und daraus beispielsweise durch eine Mittelwertbildung erzeugt wird. Die Zeitdauer zur Erfassung von Frequenzmesswerten, aus denen anschließend der abgeleitete Frequenzmesswert gebildet wird, kann beispielsweise 1s betragen, so dass bei einer Abtastrate von 50 Abtastungen pro Sekunde aus jeweils 50 Frequenzmesswerten ein abgeleiteter Frequenzmesswert höherer Genauigkeit gebildet wird. Die verwendete Zeitdauer kann jedoch auch andere Werte als 1s annehmen, insbesondere kürzer sein.

Während bei dem Ausführungsbeispiel gemäß Figur 1 die Messeinrichtung 14, mit der die Abtastwerte gebildet werden, in das Messgerät 12, mit dem die Frequenzmesswerte gebildet werden, integriert ist, ist in Figur 2 eine andere Möglichkeit beschrieben, bei der die Abtastwerte und/oder die Phasenwinkel Δφ mittels separaten Messeinrichtungen erzeugt und an das Messgerät übertragen werden.

Hierzu zeigt Figur 2 einen Teil eines ansonsten nicht näher dargestellten Energieversorgungsnetzes 20, das mehrere Netzknoten mit Abzweige aufweist. An manchen Messstellen, insbesondere in der Nähe von Netzknoten, sind Messeinrichtungen 21 (z.B. PMUs) vorgesehen, die entsprechend der hinsichtlich der Messeinrichtung 14 der Figur 1 beschriebenen Weise Abtastwerte einer Netzgröße (Wechselstrom, Wechselspannung) erzeugen. Außerdem kann vorgesehen sein, dass die Messeinrichtungen 21 auch bereits eine Vorverarbeitung der Abtastwerte dahingehend vornehmen, dass aus zwei aufeinander folgenden Abtastwerten ein Phasenwinkel Δφ bestimmt wird.

Die Messeinrichtungen 21 stehen über eine beliebige Kommunikationsverbindung 22, die in Figur 2 lediglich beispielhaft als Kommunikationsbus dargestellt ist, mit einem Messgerät in Verbindung, das gemäß dem Ausführungsbeispiel der Figur 2 Bestandteil einer Datenverarbeitungseinrichtung 23 einer Netzleitstelle ist. Die Messeinrichtungen 21 übertragen die von ihnen erzeugten Abtastwerte und/oder Phasenwinkel $\Delta\varphi$ über diese Kommunikationsverbindung 22 an das in der Datenverarbeitungseinrichtung 23 enthaltene Messgerät, das daraus entsprechend der bereits zu Figur 1 beschriebenen Vorgehensweise den Frequenzmesswert bestimmt. Außerdem kann das Messgerät aus mehreren aufeinander folgenden Frequenzmesswerten einen abgeleiteten Frequenzmesswert höherer Genauigkeit ermitteln.

Bei dem in Figur 2 gezeigten Messsystem können die Abtastwerte relativ vieler Messeinrichtungen 21 zur Bildung von Frequenzmesswerten herangezogen werden, ohne dass die Messeinrichtungen selbst die Bestimmung der Frequenz durchführen müssen.

Beide beschriebenen Ausführungsbeispiele ermöglichen es, mittels vergleichsweise einfacher Messtechnik - und damit relativ kostengünstig - eine Aussage über die an mehreren Messstellen des Energieversorgungsnetzes vorliegende Frequenz zu machen. Die mit dem beschriebenen Verfahren erreichbare Genauigkeit, insbesondere unter Nutzung des abgeleiteten Frequenzmesswertes, ist ausreichend, um hiermit Regelungsverfahren zur Netzregelung durchzuführen. Zur Messung der benötigten Abtastwerte können zudem vorteilhaft bereits heute vielfach in die Energieversorgungsnetze integrierte PMUs verwendet werden.

## Patentansprüche

1.  Verfahren zum Erzeugen eines Frequenzmesswertes, der eine an einer Messstelle (11) in einem Energieversorgungsnetz vorliegende Frequenz einer elektrischen Netzgröße angibt, bei dem mit einer Messeinrichtung (14) ein die Netzgröße charakterisierendes Signal abgetastet wird und aus den Abtastwerten der Frequenzmesswert bestimmt wird, wobei

    - der Phasenwinkel ermittelt wird, der zwischen zwei aufeinander folgenden Abtastwerten der Netzgröße liegt, und
    - der Frequenzmesswert unter Heranziehung des ermittelten Phasenwinkels berechnet wird;
    **dadurch gekennzeichnet, dass**
    - als Messeinrichtung (14) eine Zeigermesseinheit verwendet wird, die dazu eingerichtet ist, die Phasenlage eines Zeigers der Netzgröße mit einem Fehler von maximal arctan (0,01) zu bestimmen;- der Frequenzmesswert unter Heranziehung des ermittelten Phasenwinkels, der Nennfrequenz des Energieversorgungsnetzes und der Abtastrate, mit der die Abtastwerte erzeugt werden, berechnet wird;
    - der Frequenzmesswert wiederholt ermittelt wird; und
    - ein abgeleiteter Frequenzmesswert aus mehreren während einer Messzeit aufeinander folgend ermittelten Frequenzmesswerten berechnet wird.

2.  Verfahren nach Anspruch 1,
    **dadurch gekennzeichnet, dass**

    - der Phasenwinkel zwischen zwei unmittelbar aufeinander folgenden Abtastwerten der Netzgröße ermittelt wird.

3.  Verfahren nach Anspruch 1 oder 2,
    **dadurch gekennzeichnet, dass**

    - als Netzgröße eine an der Messstelle (11) vorliegende Wechselspannung oder ein an der Messstelle (11) fließender Wechselstrom verwendet wird.

4.  Verfahren nach einem der vorangehenden Ansprüche,
    **dadurch gekennzeichnet, dass**

    - der Frequenzmesswert gemäß der folgenden Gleichung ermittelt wird:

$$f = f_n \cdot \left(1 + \frac{\Delta\varphi}{360°} \cdot \frac{r}{f_n}\right),$$

    mit

f : zu ermittelnder Frequenzmesswert,

f_n : Nennfrequenz des Energieversorgungsnetzes,

$\Delta\varphi$ : ermittelter Phasenwinkel,

r : Abtastrate der Messeinrichtung (14).

**5.** Verfahren nach einem der vorangehenden Ansprüche,
**dadurch gekennzeichnet, dass**

- der abgeleitete Frequenzmesswert durch Mittelwertbildung aus den mehreren ermittelten Frequenzmesswerten berechnet wird.

**6.** Elektrisches Messgerät (12) zum Erzeugen eines Frequenzmesswertes, der eine an einer Messstelle (11) in einem Energieversorgungsnetz vorliegende Frequenz einer Netzgröße angibt, das mit einer Messeinrichtung (14) verbindbar ist, die dazu eingerichtet ist, ein die Netzgröße charakterisierendes Signal unter Bildung von Abtastwerten abzutasten, aus denen der Frequenzmesswert bestimmbar ist,
**dadurch gekennzeichnet, dass**

- die Messeinrichtung (14) eine Zeigermesseinheit ist, die dazu eingerichtet ist, die Phasenlage eines Zeigers der Netzgröße mit einem Fehler von maximal arctan (0,01) zu bestimmen; und
- das elektrische Messgerät (12) zur Durchführung eines Verfahrens gemäß einem der vorangehenden Ansprüche eingerichtet ist.

**7.** Elektrisches Messgerät (12) nach Anspruch 6,
**dadurch gekennzeichnet, dass**

- das elektrische Messgerät (12) die Messeinrichtung (14) umfasst.

**8.** Elektrisches Messgerät nach Anspruch 6,
**dadurch gekennzeichnet, dass**

- das elektrische Messgerät über eine Kommunikationsverbindung mit der Messeinrichtung verbindbar ist und dazu eingerichtet ist, über die Kommunikationsverbindung die Abtastwerte und/oder den aus den Abtastwerten ermittelten Phasenwinkel zu empfangen und daraus den Frequenzmesswert zu bestimmen.

**Claims**

**1.** Method for generating a frequency measurement value indicating a frequency of an electrical network variable present at a measurement point (11) in an energy supply network, in which method a signal characterizing the network variable is sampled by a measurement device (14) and the frequency measurement value is determined from the samples, wherein

- the phase angle between two successive samples of the network variable is ascertained, and
- the frequency measurement value is calculated using the phase angle ascertained;
**characterized in that**
- the measurement device (14) used is a phasor measurement unit configured to determine the phase angle of a phasor of the network variable with an error of a maximum of arctan (0.01);
- the frequency measurement value is calculated using the phase angle ascertained, the nominal frequency of the energy supply network and the sampling rate at which the samples are generated;
- the frequency measurement value is ascertained repeatedly; and
- a derived frequency measurement value is calculated from a plurality of frequency measurement values ascertained successively during a measurement time.

**2.** Method according to Claim 1,
**characterized in that**

- the phase angle between two directly successive samples of the network variable is ascertained.

**3.** Method according to Claim 1 or 2,
**characterized in that**

- an AC voltage present at the measurement point (11) or an AC current flowing at the measurement point (11) is used as the network variable.

**4.** Method according to any of the preceding claims,
**characterized in that**

- the frequency measurement value is ascertained in accordance with the following equation:

$$f = f_n \cdot \left(1 + \frac{\Delta \varphi}{360°} \cdot \frac{r}{f_n}\right),$$

where

f : frequency measurement value to be ascertained,
$f_n$ : nominal frequency of the energy supply network,
$\Delta\varphi$ : phase angle ascertained,
r : sampling rate of the measurement device (14).

**5.** Method according to any of the preceding claims, **characterized in that**

- the derived frequency measurement value is calculated by averaging from the plurality of frequency measurement values ascertained.

**6.** Electrical measurement instrument (12) for generating a frequency measurement value indicating a frequency of a network variable present at a measurement point (11) in an energy supply network, which electrical measurement instrument is connectable to a measurement device (14) configured to sample a signal characterizing the network variable to form samples, from which the frequency measurement value is determinable, **characterized in that**

- the measurement device (14) is a phasor measurement unit configured to determine the phase angle of a phasor of the network variable with an error of a maximum of arctan (0.01); and
- the electrical measurement instrument (12) is configured for carrying out a method according to any of the preceding claims.

**7.** Electrical measurement instrument (12) according to Claim 6, **characterized in that**

- the electrical measurement instrument (12) comprises the measurement device (14).

**8.** Electrical measurement instrument according to Claim 6, **characterized in that**

- the electrical measurement instrument is connectable to the measurement device via a communication connection and is configured to receive via the communication connection the samples and/or the phase angle ascertained from the samples and to determine the frequency measurement value therefrom.

**Revendications**

**1.** Procédé de production d'une valeur de mesure de fréquence, qui indique une fréquence, présente en un point (11) de mesure, dans un réseau d'alimentation en énergie, d'une grandeur de réseau électrique énergie dans lequel on échantillonne, par un dispositif (14) de mesure, un signal caractérisant la grandeur du réseau et on détermine la valeur de mesure de la fréquence à partir des valeurs d'échantillonnage, dans lequel

- on détermine l'angle de phase entre deux valeurs d'échantillonnage successives de la grandeur du réseau, et
- on calcule la valeur de mesure de la fréquence en tirant parti de l'angle de phase déterminé;

**caractérisé en ce que**
- comme dispositif (14) de mesure, on utilise une unité de mesure de vecteur conçue pour déterminer la position en phase d'un vecteur de la grandeur du réseau avec une erreur d'arctangente (0,01) au maximum, on calcule la valeur de mesure de la fréquence en tirant parti de l'angle de phase déterminé, de la fréquence nominale du réseau d'alimentation en énergie et du taux d'échantillonnage, auquel les valeurs d'échantillonnage sont produites;
- on répète la détermination de la valeur de mesure de la fréquence; et
- on calcule une valeur de mesure de la fréquence déduite de plusieurs valeurs de mesure de la fréquence, déterminées successivement pendant un temps de mesure.

2. Procédé suivant la revendication 1,
   **caractérisé en ce que**

   - on détermine l'angle de phase entre deux valeurs d'échantillonnage se suivant immédiatement de la grandeur du réseau.

3. Procédé suivant la revendication 1 ou 2,
   **caractérisé en ce que**

   - on utilise comme grandeur du réseau une tension alternative présente au point (11) de mesure ou un courant alternatif passant au point (11) de mesure.

4. Procédé suivant l'une des revendications précédentes,
   **caractérisé en ce que**

   - on détermine la valeur de la mesure de la fréquence par l'équation suivante :

$$\mathrm{f} = \mathrm{f_n} \cdot \left( 1 + \frac{\Delta\varphi}{360°} \cdot \frac{r}{f_n} \right),$$

   dans lequel

   f : est la valeur de la mesure de la fréquence à déterminer,
   $f_n$ : est la fréquence nominale du réseau d'alimentation en énergie,
   $\Delta\varphi$ : est l'angle de phase déterminé,
   r : est le taux d'échantillonnage du dispositif (14) de mesure.

5. Procédé suivant l'une des revendications précédentes, **caractérisé en ce que**

   - on calcule la valeur de mesure de la fréquence déduite en formant la moyenne de plusieurs valeurs de mesure de la fréquence qui ont été déterminées.

6. Appareil (12) électrique de mesure pour produire une valeur de mesure de la fréquence, qui indique une fréquence, présente en un point (11) de mesure dans un réseau d'alimentation en énergie, d'une grandeur du réseau, appareil (12), qui peut être relié à un dispositif (14) de mesure, conçu pour échantillonner un signal caractérisant la grandeur du réseau en formant des valeurs d'échantillonnage à partir desquelles la valeur de mesure de la fréquence peut être déterminée,
   **caractérisé en ce que**

   - le dispositif (14) de mesure est une unité de mesure de vecteur conçue pour déterminer la position en phase d'un vecteur de la grandeur du réseau à une erreur d'arctangente (0,01) au maximum; et
   - l'appareil (12) électrique de mesure est conçu pour effectuer un procédé suivant l'une des revendications précédentes.

7. Appareil (12) électrique de mesure suivant la revendication 6,
   **caractérisé**

- **en ce que** l'appareil (12) électrique de mesure comprend le dispositif (14) de mesure.

8. Appareil (12) électrique de mesure suivant la revendication 6,
   **caractérisé en ce que**

   - l'appareil électrique de mesure peut être relié au dispositif de mesure par une liaison de communication et est conçu pour recevoir, par la liaison de communication, les valeurs d'échantillonnage et/ou l'angle de phase déterminé à partir des valeurs d'échantillonnage et en déterminer la valeur de mesure de la fréquence.

FIG 1

FIG 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3149165 A1
- DE 4211946 C1
- EP 0311825 A
- GB 2027297 A
- EP 2113776 A
- DE 102007037060
- EP 2095482 B1